Europäisches Patentamt

European Patent Office

Office européen des brevets

(19)

(11) EP 0 579 561 B1

(12) **FASCICULE DE BREVET EUROPEEN**

(45) Date de publication et mention
de la délivrance du brevet:
**03.12.1997 Bulletin 1997/49**

(51) Int Cl.⁶: **H02H 9/04**, H02H 3/02,
H03K 17/08

(21) Numéro de dépôt: **93420292.0**

(22) Date de dépôt: **05.07.1993**

(54) **Circuit de protection d'un composant de puissance contre des surtensions directes**

Schutzschaltung gegen Überspannungen für Leistungsbauteil

Protection circuit for power components against overvoltages

(84) Etats contractants désignés:
**DE FR GB IT**

(30) Priorité: **16.07.1992 FR 9209119**

(43) Date de publication de la demande:
**19.01.1994 Bulletin 1994/03**

(73) Titulaire: **SGS-THOMSON MICROELECTRONICS
S.A.
94250 Gentilly (FR)**

(72) Inventeurs:
• **Meunier, Philippe
F-13100 Aix-en-Provence (FR)**
• **Pavlin, Antoine
F-13540 Puyricard (FR)**

(74) Mandataire: **de Beaumont, Michel
1, rue Champollion
38000 Grenoble (FR)**

(56) Documents cités:
EP-A- 0 321 663    EP-A- 0 397 017
WO-A-92/03646    US-A- 4 860 152

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

## Description

La présente invention concerne la protection de composants de puissance du type transistor MOS vertical (VDMOS) ou transistor bipolaire à grille isolée (IGBT) contre des surtensions.

Dans ce qui suit, on se réfèrera toujours à des transistors de puissance de type MOS. Toutefois, il sera clair que tout ce qui est énoncé à propos de ces transistors s'applique également à des transistors bipolaires à grille isolée (IGBT) qui sont structurellement sensiblement identiques à l'exception du fait qu'ils comprennent du côté de leur face arrière une couche supplémentaire de type de conductivité opposée à celle constituant la face arrière d'un transistor MOS de puissance.

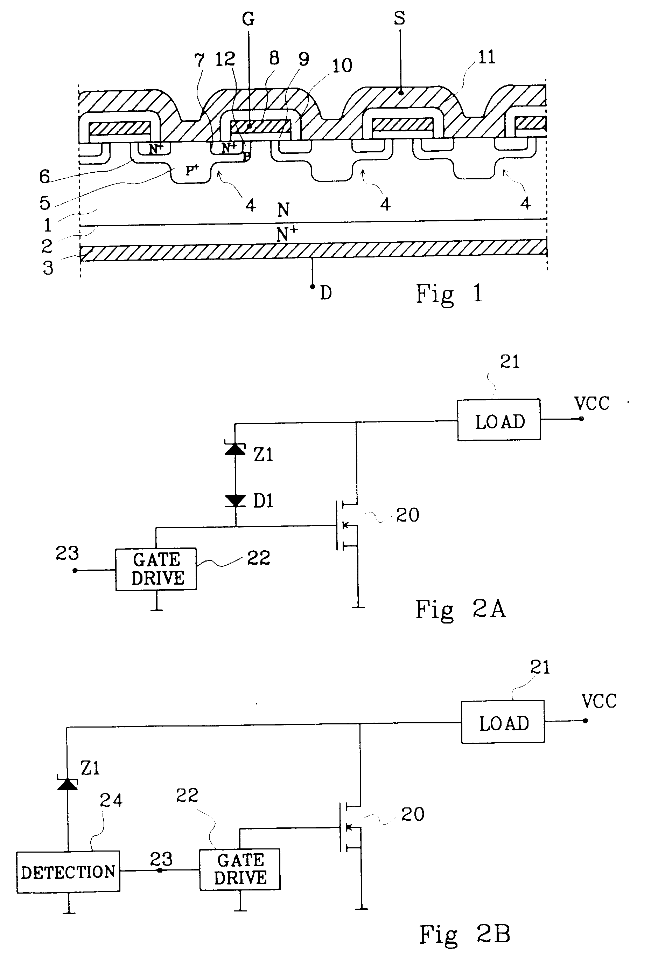

La figure 1 représente une vue en coupe schématique d'un mode de réalisation classique d'un transistor MOS vertical. Ce transistor est formé dans un substrat 1 de type N dont la face arrière comprend une couche surdopée 2 de type N+ revêtue d'une métallisation de drain 3. Dans la face avant sont formés des caissons 4 de type P comprenant une région centrale plus fortement dopée 5 et une région périphérique plus faiblement dopée 6. La périphérie interne de chaque caisson comprend une région diffusée de type N fortement dopée 7. A cheval entre deux caissons ou cellules adjacents est formée une grille conductrice 8 au-dessus d'une couche isolante 9. La grille est protégée par une couche d'isolant 10 et l'ensemble de la face supérieure est revêtu d'une métallisation de source 11 en contact avec les régions N+ et la partie centrale de chaque cellule.

Ce transistor est rendu conducteur entre son drain et sa source, le drain étant positif par rapport à la source, quand une tension est appliquée sur la grille. Alors un courant s'écoule à partir du drain en passant par le substrat 1 et une région de canal formée à la partie supérieure 12 des caissons P sous la région de grille, vers la région 7 et la métallisation de source.

Un transistor bipolaire à grille isolée (IGBT) se différencie dans sa structure du transistor VDMOS représenté en figure 1 en ce que sa région 2 est de type P+ au lieu d'être de type N+. Ses électrodes principales sont alors généralement appelées émetteur et collecteur et sa borne de commande est toujours appelée grille.

Un composant du type de celui de la figure 1 ne devrait donc pouvoir entrer à l'état de conduction que quand son drain est positif par rapport à sa source et qu'un signal est appliqué sur sa grille. Néanmoins, quand une tension élevée est appliquée sur le drain par rapport à la source, la jonction entre le substrat 1 et le caisson 5, 6 est susceptible d'entrer en avalanche. Cette mise en conduction est indésirable car elle peut provoquer un échauffement de la zone où se crée l'avalanche en raison d'une circulation de courant excessive et cet échauffement peut être destructif.

On cherche donc à éviter cette mise en avalanche spontanée et il a déjà été prévu dans l'art antérieur divers moyens pour détecter le fait qu'il apparaît aux bornes du composant une surtension proche de sa tension d'avalanche et pour le mettre en conduction avant que cette valeur d'avalanche ne soit atteinte.

On distingue classiquement deux types de circuits de protection, le premier étant un circuit du type écrêteur (CLAMP) et le deuxième étant un circuit de mise en conduction complète (CROWBAR).

Les figures 2A et 2B représentent le montage d'un transistor de puissance 20 dont la source est reliée à la masse et dont le drain est relié à une première borne d'une charge 21 dont la deuxième borne est reliée à une borne d'alimentation positive VCC. La commande de mise en conduction du transistor 20 est assurée par un circuit de commande de grille 22 (GATE DRIVE). Le circuit 22 est généralement commandé à partir d'une borne d'accès externe 23.

La figure 2A représente plus particulièrement un montage de protection de type écrêteur (CLAMP). Entre le drain et la grille du transistor MOS 20 sont connectés en série, tête-bêche, une diode à avalanche (couramment appelée diode zener) Z1 et une diode D1. La diode zener Z1 a une tension d'avalanche qui est choisie légèrement inférieure, habituellement quelques dizaines de volts, à la tension d'avalanche du transistor MOS 20. La diode D1 est prévue pour empêcher, en fonctionnement normal, tout courant de grille de circuler vers le drain du transistor.

Dans ce circuit, quand une surtension d'amplitude supérieure à la tension d'avalanche 21 de la diode zener Z1, additionnée de la chute de tension VF de la diode D1 et de la tension de seuil grille-source VGS du transistor 20 apparaît, le transistor MOS entre en conduction. On suppose pour simplifier que le courant de fuite dans le circuit de commande de grille 22 est négligeable. Toutefois, pendant cette mise en conduction du transistor 20, le drain de ce transistor reste au potentiel VZ1+VF+VGS, c'est-à-dire que la chute de tension aux bornes du transistor MOS est importante et que celui-ci n'est que dans un état de mise en conduction partielle. L'énergie sera donc essentiellement dissipée dans le transistor qui présente une chute de tension aux bornes élevée et un courant non négligeable. Si cette énergie est importante, elle est susceptible de détruire par échauffement le transistor MOS. Ainsi, le mode de protection de type écrêteur susmentionné ne s'applique qu'au cas où l'on souhaite réaliser une protection contre des surcharges de faible énergie. Ceci se produit par exemple après la commutation à l'ouverture d'une charge légèrement inductive. L'avantage de ce mode de protection est que la mise en conduction du transistor MOS s'arrête dès que la surtension disparaît.

La figure 2B représente un circuit de protection du type à mise en conduction complète (CROWBAR). Dans ce cas, la diode zener Z1 reliée au drain du transistor 20 est associée à un circuit de détection de surtension 24. Dès qu'une surtension apparaît, le circuit 24 fournit un signal sur la borne 23 du circuit de commande de grille 22 et celui-ci provoque la mise en conduction du transistor 20. Une fois que le transistor 20 est mis en conduction par son circuit de commande de grille 22, la tension à ses bornes chute à une valeur faible (RON) et il n'est plus possible de déterminer par le circuit de détection 24 si une surtension est encore présente ou non. L'avantage de ce type de montage est que, comme la tension aux bornes du transistor 20 chute à une valeur faible, peu d'énergie sera dissipée dans ce transistor. L'inconvénient est que cette protection est amorcée même pour des surcharges de très faible énergie pour lesquelles une telle protection est superfétatoire.

En résumé, on se trouve dans l'art antérieur en présence de deux types de circuit de protection. L'un convient bien à des protections contre des surtensions de faible énergie mais est susceptible d'entraîner une destruction du composant si l'énergie de la surtension est trop élevée. L'autre convient bien à des surtensions de forte énergie mais perturbe indûment le fonctionnement du commutateur quand il s'agit seulement d'éliminer des surtensions de faible énergie.

Le document EP-A-0397017 décrit un circuit de protection d'un transistor de puissance de type MOS vertical ou IGBT à l'état bloqué à l'encontre de surtensions directes, comprenant : des premiers moyens de mise en conduction pour limiter la tension aux bornes du transistor de puissance à une tension prédéterminée inférieure à la tension de claquage en direct du transistor de puissance ; des moyens de détection de la quantité d'énergie dissipée dans le transistor de puissance tandis que les premiers moyens sont actifs ; des seconds moyens de mise en conduction à basse impédance du transistor de puissance, actifs quand les moyens de détection ont détecté que l'énergie dissipée a dépassé une valeur de seuil d'énergie prédéterminée.

Un objet de la présente invention est de réaliser un tel système de protection adapté à des technologies de type transistor MOS "intelligent" (SMART POWER MOS) dans lesquelles un transistor de puissance et des composants logiques de commande de ce transistor de puissance sont intégrés sur une même puce semiconductrice.

Selon la présente invention, les moyens de détection comprennent : des moyens de charge d'un condensateur à une tension déterminée tandis que le transistor de puissance est à l'état bloqué ; des moyens pour interrompre la charge du condensateur et des moyens pour le décharger par un courant de décharge proportionnel au courant dans le transistor de puissance, dès que le transistor de puissance commence à entrer en conduction sous l'effet des premiers moyens ; et des moyens de détection de la tension aux bornes du condensateur.

Selon un mode de réalisation de la présente invention, les premiers moyens comprennent le montage en série d'une diode zener et d'une diode tête-bêche, ce montage étant connecté entre drain et grille du transistor de puissance.

Selon un mode de réalisation de la présente invention, les seconds moyens comprennent des moyens d'activation d'un circuit de commande de grille.

Selon un mode de réalisation de la présente invention, les moyens de charge comprennent une source de courant commandée par un inverseur dont la borne d'entrée est connectée d'une part à la masse par l'intermédiaire d'une résistance de valeur élevée, d'autre part au point de connexion entre ladite diode zener et ladite diode.

Selon un mode de réalisation de la présente invention, ledit condensateur est connecté en parallèle avec une diode zener de fixation de tension de charge maximale.

Selon un mode de réalisation de la présente invention, la tension aux bornes du condensateur est détectée par un inverseur dont la deuxième borne est connectée à une borne d'activation du circuit de commande de grille.

Selon un mode de réalisation de la présente invention, le courant de décharge est obtenu à partir d'un miroir de courant recopiant, éventuellement avec un facteur de division, le courant dans un transistor de détection constitué d'un certain nombre de cellules identiques aux cellules constituant le transistor principal.

Selon un mode de réalisation de la présente invention, la source de courant de décharge du condensateur est constituée d'un transistor en série avec une résistance, le point de connexion de ce transistor et de cette résistance étant relié à l'entrée inverseuse d'un amplificateur opérationnel dont l'entrée non-inverseuse reçoit le courant du transistor de détection et est reliée à la masse par l'intermédiaire d'une résistance de polarisation.

Ainsi, grâce au circuit selon la présente invention, en cas d'apparition d'une surtension de faible énergie, celle-ci est limitée à une valeur d'écrêtage (CLAMPING) et le transistor repasse immédiatement à l'état bloqué à la fin de la surtension. Par contre, si une surtension de forte énergie apparait, on passe d'abord à l'état d'écrêtage puis ensuite, dès que le passage dans le composant d'une énergie supérieure à un seuil déterminé a été détecté, le composant est mis dans son état de conduction complète avec une faible chute de tension entre ses bornes principales.

Ces objets, caractéristiques et avantages ainsi que d'autres de la présente invention seront exposés en détail dans la description suivante de modes de réalisation particuliers faite en relation avec les figures jointes parmi lesquelles :

les figures 1, 2A et 2B, décrites précédemment, représentent respectivement une vue en coupe d'un transistor MOS vertical de puissance et des schémas de circuits de protection classiques ;
la figure 3 représente un schéma bloc d'un circuit selon EP-A-0 397 017 ;
la figure 4 représente un schéma plus détaillé d'un mode de réalisation de la présente invention ;
la figure 5 est une courbe de tension en fonction du temps destinée à expliquer le fonctionnement du circuit de la figure 4 ; et
la figure 6 représente un mode de réalisation plus détaillé de la présente invention.

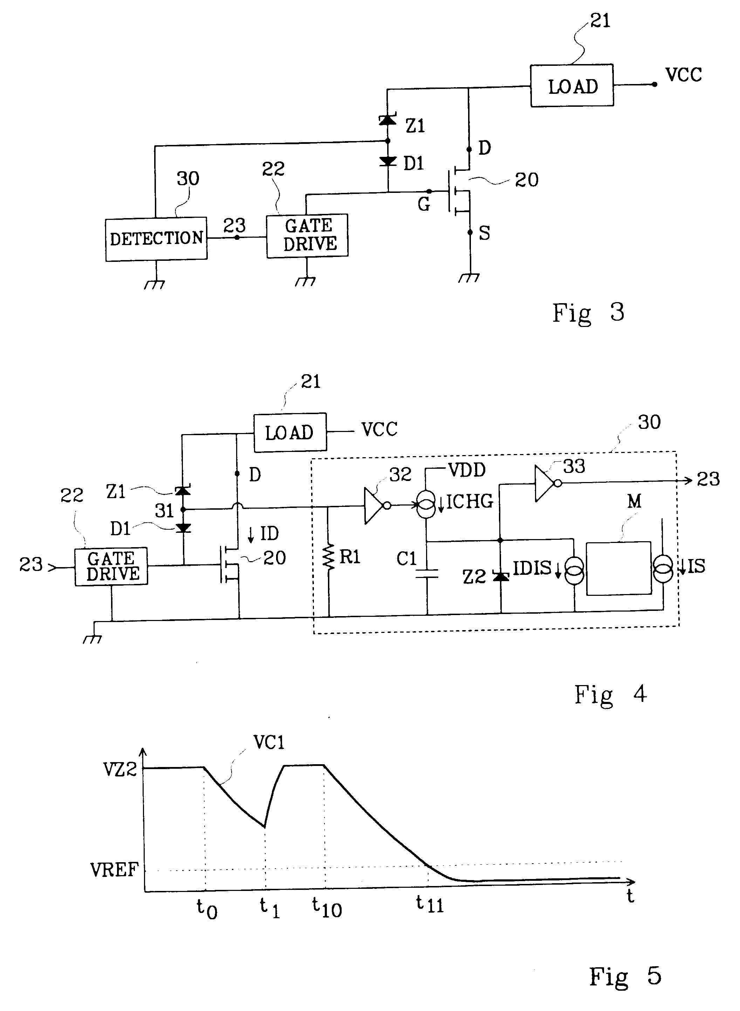

La figure 3 représente un transistor MOS de puissance 20 dont le drain D est connecté à une première borne d'une charge 21 dont l'autre borne est reliée à une tension d'alimentation VCC. La source S du transistor 20 est reliée à la masse. Le drain D du transistor 20 est en outre relié à sa grille par l'intermédiaire de la connexion en série, tête-bêche, d'une diode zener Z1 et d'une diode D1. En outre, la grille du transistor 20 est reliée à un circuit de commande de grille classique (GATE DRIVE) 22 comprenant une borne de commande 23.

Le circuit décrit jusqu'à présent est identique au circuit de l'art antérieur de la figure 2A. Il fonctionne en écrêteur, c'est-à-dire que dès qu'une surtension apparaît sur la borne de drain D, le potentiel de cette borne est limité à une tension VZ1+VF+VGS. Comme on l'a vu précédemment, ce mode de protection en écrêteur présente l'inconvénient de provoquer un échauffement excessif du transistor 20 si l'énergie de la surcharge est trop importante.

Pour éviter cet inconvénient, la présente invention prévoit un circuit de détection de surcharge 30 qui, à partir du moment où une surtension apparaît, c'est-à-dire du moment où la diode zener Z1 est devenue passante, détecte l'énergie dissipée dans le transistor 20 et envoie un signal de commande sur la borne 23 du circuit de commande de grille 22 dès qu'une valeur de seuil d'énergie est atteinte.

On notera qu'il ne faut pas confondre le circuit de détection 30 selon l'invention, qui est un circuit de détection d'énergie, avec le circuit de détection 24, utilisé dans le circuit de la figure 2B de l'art antérieur, qui est un circuit de détection de surtension qui devient actif dès qu'une surtension apparaît.

La figure 4 reprend les principaux éléments du circuit de la figure 3 mais le circuit de détection d'énergie 30 est représenté plus en détail. Ce circuit est connecté au point de raccordement 31 des diodes Z1 et D1. La borne 31 est reliée à la masse par une résistance de valeur élevée R1 et à l'entrée d'un circuit de commmande de charge 32 représenté sous forme d'un simple inverseur. La sortie de l'inverseur 32 est reliée à la borne de commande d'une source de courant de charge ICHG. Cette source de courant de charge est destinée à charger un condensateur C1 en parallèle sur une diode zener Z2 et une source de courant de décharge IDIS. La source de courant de décharge reproduit, par l'intermédiaire d'un miroir de courant diviseur M, un courant IS proportionnel au courant circulant dans le transistor principal. La tension aux bornes du condensateur C1 est détectée par un circuit comparateur 33 représenté sous forme d'un simple inverseur dont la sortie alimente la borne de mise en route 23 du circuit de commande de grille 22.

Le fonctionnement du circuit de détection d'énergie 30 est le suivant. Tandis que le transistor 20 est bloqué et en l'absence de surtension, la borne 31, correspondant à l'entrée de l'inverseur 32, est au niveau de la masse fixé par la résistance R1. La source de courant ICHG est alors active et le condensateur C1 se charge jusqu'à ce que sa tension atteigne la tension d'avalanche de la diode zener Z2 qui est par exemple de 10 volts. Alors, l'entrée de l'inverseur 33 est à niveau haut, sa sortie est à niveau bas et le circuit de commande de grille 22 n'est pas activé, c'est-à-dire que le transistor 20 reste à l'état bloqué, sous réserve que le circuit de commande de grille 22 ne soit pas commandé par ailleurs.

Quand la tension sur la borne de drain D du transistor 20 devient supérieure à la tension de claquage de la diode zener Z1 (plus la chute de tension VF de la diode D1 et la chute de tension grille-source VGS du transistor 20), la diode zener Z1 devient passante et la borne 31 passe à haut niveau. L'inverseur 32 interrompt alors le fonctionnement du circuit de charge ICHG et la capacité C1 est déchargée par la source de courant IDIS. Quand la tension aux bornes du condensateur C1 atteint la tension de seuil VREF de l'inverseur 33, celui-ci commute et le circuit de commande de grille 22 est mis en route pour rendre le transistor 20 complètement passant tandis que la diode zener Z1 se rebloque. Le condensateur C1 se recharge alors et l'inverseur 33 refournit un signal à bas niveau mais la commande de grille est conçue pour que ce passage de haut à bas niveau de l'entrée 23 du circuit de commande de grille n'interrompe pas le fonctionnement de ce circuit de commande de grille.

La figure 5 illustre la variation de tension VC1 sur le condensateur C1. On suppose d'abord qu'à un instant t0 le transistor 20 est bloqué. Le condensateur C1 est alors chargé et la tension à ses bornes est égale à VZ2. Quand une surtension apparaît, le condensateur C1 se décharge sous l'effet de la source de courant IDIS. Si, à un instant t1, la surtension s'interrompt, le condensateur C1 se recharge et aucun signal n'a été fourni sur la borne 23. Le transistor 20 reprend donc immédiatement son état bloqué. Ensuite, on suppose qu'à un instant t10, une nouvelle surtension apparaît. Si cette surtension est longue et de forte énergie, le condensateur C1 se décharge complètement et, quand la tension à ses bornes atteint la tension de référence VREF, le signal 23 est fourni et le transistor 20 se met en conduction de façon durable.

On va montrer que le fait que l'on atteint le seuil VREF de décharge du condensateur C1 est caractéristique de la dissipation d'une certaine quantité d'énergie dans le transistor 20. En effet, quand ce transistor est à l'état passant, si l'on appelle VD sa tension de drain et ID son courant de drain, l'énergie qui y est dissipée entre des instants t10 et t11 est égale à :

$$E = \int_{t10}^{t11} VD \cdot ID \cdot dt = (VZ1+VF+VGS) \int_{t10}^{t11} ID \cdot dt \qquad (1)$$

(On s'est placé dans le cas où VD est fixé à VZ1+VF+VGS, c'est-à-dire dans une situation d'écrêtage).

En fait, comme on l'a indiqué précédemment, le courant de décharge IDIS est proportionnel au courant ID, c'est-à-dire que ID = K.IDIS. En conséquence :

$$E = K \cdot (VZ1+VF+VGS) \int_{t10}^{t11} IDIS \cdot dt \qquad (2)$$

En se référant à la figure 5, on voit que :

$$VZ2 - VREF = 1/C1 \times \int_{t10}^{t11} IDIS \cdot dt \qquad (3)$$

En combinant les équations (2) et (3) on obtient:

$$E = K \cdot C1 \cdot (VZ1+VF+VGS) \cdot (VZ2-VREF) \qquad (4)$$

Cette équation montre que la mise en action du circuit de commande de grille 22 survient quand l'énergie E dissipée dans le transistor MOS 20 dépasse une valeur de seuil prédéterminée qui dépend des valeurs des composants du circuit. Ces valeurs sont choisies de sorte que l'énergie de seuil E soit l'énergie maximale que le circuit de puissance peut dissiper avant d'être détruit. Le circuit selon la présente invention permet donc d'atteindre les objets recherchés.

Par ailleurs, comme on l'a indiqué précédemment, la présente invention se prête tout particulièrement à une application dans le domaine des circuits de puissance intelligents (SMART POWER CHIP) dans lesquels on peut réaliser sur une même puce de circuit intégré des composants de puissance tel que le transistor 20 constitué de nombreuses cellules identiques du type de celles de la figure 1 et des composants logiques réalisés dans un ou plusieurs caissons P formés dans le substrat 1 de la figure 1.

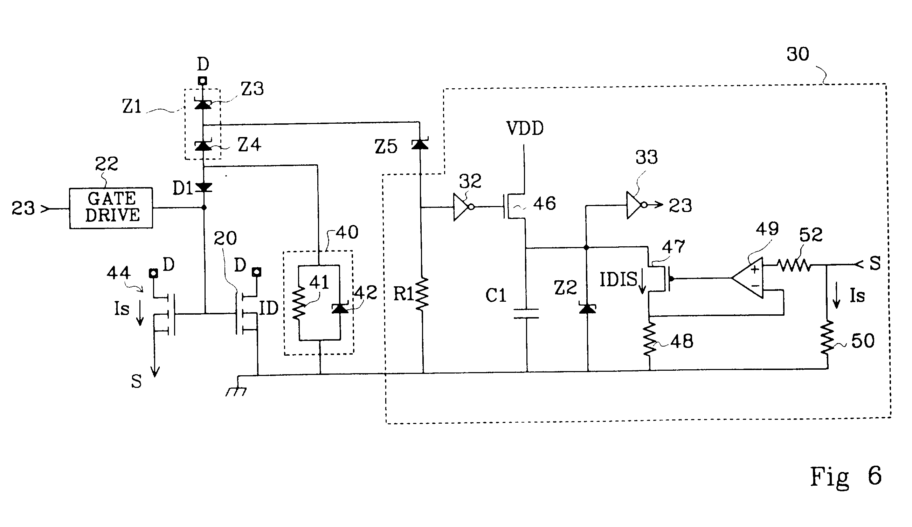

La figure 6 représente à titre d'exemple un mode de réalisation de la présente invention adapté à cette technologie. Dans le circuit de la figure 6, de mêmes éléments qu'en figure 4 sont désignés par de mêmes références. Plus particulièrement, le circuit de la figure 6 comprend le transistor de puissance 20, la diode zener Z1, la diode D1, le circuit de commande de grille 22 et son entrée de commande 23, et le circuit de détection d'énergie dissipée 30 comprenant la résistance R1, l'inverseur 32, le condensateur C1, la diode zener Z2, l'inverseur 33 et sa sortie 23.

Dans le circuit de la figure 6, la diode zener Z1 est décomposée en deux diodes, Z3 et Z4 ayant par exemple respectivement des tensions d'avalanche de 440 et de 10 volts pour une tension totale de 450 volts. Une diode zener Z5 sensiblement identique à la diode zener Z4 est interposée entre le point de raccordement des diodes Z3 et Z4 et l'entrée de l'inverseur 32. Les diodes zener Z4 et Z5 sont destinées à éviter la circulation de courant de fuite entre le circuit de contrôle d'énergie 30 et le circuit de commande de grille 22.

Entre le point de connexion de la diode zener Z4 et de la diode D1 et la masse est disposé un circuit de protection 40 comprenant en parallèle une résistance 41 et une diode zener 42. La résistance 41 peut par exemple être réalisée par un transistor MOS à appauvrissement facilement réalisable dans la technologie considérée. La fonction de cette résistance 41 est d'éviter que le courant de fuite éventuel de la diode zener Z1 (Z3-Z4) ne polarise le transistor MOS 20 en fonctionnement normal. La diode zener 42 a pour objet une protection du transistor à appauvrissement constituant la résistance 41 pour limiter sa tension de drain à une dizaine de volts.

En parallèle sur le transistor de puissance 20, c'est-à-dire avec la même connexion de drain et la même connexion de grille est disposé un transistor de détection 44 dans lequel circule un courant IS proportionnel au courant dans le transistor principal 20. En pratique, ce transistor de détection sera constitué d'un certain nombre de cellules identiques aux cellules du transistor principal. Par exemple, si le transistor principal contient 10000 cellules, le transistor 44 pourra contenir 10 cellules et sera donc parcouru par un courant mille fois plus petit que le transistor principal.

La source de courant de charge ICHG est réalisée par un transistor MOS 46 dont la grille est connectée à la sortie de l'inverseur 32. La résistance R1 peut, comme la résistance 41, être réalisée par un transistor MOS à appauvrissement.

La figure 6 détaille plus particulièrement le circuit de détection d'énergie 30 et la réalisation de sa source de courant IDIS proportionnel au courant IS et donc au courant dans le transistor principal.

Le courant de décharge IDIS est produit par un transistor 47 en série avec une résistance 48 dont la deuxième borne est reliée à la masse. Le point de connexion du transistor 47 et de la résistance 48 est connecté à l'entrée (-) d'un amplificateur opérationnel 49. L'autre entrée (+) de l'amplificateur opérationnel 49 est connectée à la source S du transistor de détection 44. Cette connexion à la source S est également reliée à la masse par l'intermédiaire d'une résistance 50.

Ainsi, en l'absence de courant IS, l'entrée non-inverseuse (+) de l'amplificateur 49 est au potentiel de la masse puisqu'aucun murant n'est envoyé dans la résistance 50, et l'amplificateur 49 polarise le transistor 47 pour que son entrée inverseuse (-) soit également au potentiel de la masse, c'est-à-dire qu'aucun courant ne circule dans la résistance 48 et que le courant IDIS est nul. Par contre, quand un courant IS circule dans la résistance 50, un courant proportionnel au rapport des valeurs des résistances 48 et 50 circulera dans la résistance 48. On obtient donc bien un courant IDIS proportionnel au courant IS et donc au courant de drain ID dans le transistor principal. Comme on l'a indiqué précédemment, le rapport entre ces courants dépend du rapport entre le nombre de cellules constituant les transistors 20 et 44 et du rapport entre les résistances 50 et 48.

On a en effet intérêt à utiliser un courant IDIS très faible pour pouvoir avoir un condensateur C1 de petite valeur, de l'ordre de quelques picofarads, et donc facilement intégrable. On pourra alors choisir, pour obtenir un déclenchement de la protection de type CROWBAR pour des surcharges d'une énergie de l'ordre du joule et une excursion de tension aux bornes du condensateur C1 de quelques volts, un rapport entre le courant IDIS et le courant de drain ID du transistor 20 de l'ordre de $10^7$. Ce rapport est obtenu en choisissant un rapport 1000 entre ID et IS et un rapport 10000 entre les résistances 48 et 50.

On a également représenté en figure 6 une résistance 52 en série sur l'entrée (+) de l'amplificateur opérationnel 49 pour que les deux entrées de cet amplificateur présentent des trajets résistifs de même valeur vers la masse pour réduire les tensions de décalage qui pourraient modifier le fonctionnement de cet amplificateur.

**Revendications**

1. Circuit de protection d'un transistor de puissance de type MOS vertical ou IGBT à l'état bloqué à l'encontre de surtensions directes, comprenant :

   des premiers moyens (Z1, D1) de mise en conduction pour limiter la tension aux bornes du transistor de puissance à une tension prédéterminée (VZ1+VF+VGS) inférieure à la tension de claquage en direct du transistor de puissance,
   des moyens (24) de détection de la quantité d'énergie dissipée dans le transistor de puissance tandis que les premiers moyens sont actifs,
   des seconds moyens (22, 23) de mise en conduction à basse impédance du transistor de puissance, actifs quand les moyens de détection ont détecté que l'énergie dissipée a dépassé une valeur de seuil d'énergie prédéterminée,

   caractérisé en ce que les moyens de détection comprennent :

   des moyens (ICHG) de charge d'un condensateur (C1) à une tension déterminée (VZ2) tandis que le transistor de puissance est à l'état bloqué,
   des moyens (32) pour interrompre la charge du condensateur et des moyens pour le décharger par un courant de décharge (IDIS) proportionnel au courant dans le transistor de puissance, dès que le transistor de puissance commence à entrer en conduction sous l'effet des premiers moyens, et
   des moyens de détection de la tension aux bornes du condensateur.

2. Circuit de protection selon la revendication 1, caractérisé en ce que les premiers moyens comprennent le montage en série d'une diode zener (Z1) et d'une diode (D1) tête-bêche, ce montage étant connecté entre drain et grille du transistor de puissance.

3. Circuit de protection selon la revendication 1, caractérisé en ce que les seconds moyens comprennent des moyens d'activation (23) d'un circuit de commande de grille (22).

4. Circuit selon les revendications 1 et 2, caractérisé en ce que les moyens de charge comprennent une source de courant commandée par un inverseur (32) dont la borne d'entrée est connectée d'une part à la masse par l'intermédiaire d'une résistance de valeur élevée (R1), d'autre part au point de connexion entre ladite diode zener (Z1) et ladite diode (D1).

5. Circuit de protection selon la revendication 1, caractérisé en ce que ledit condensateur (C1) est connecté en parallèle avec une diode zener (Z2) de fixation de tension de charge maximale.

6. Circuit de protection selon la revendication 1, caractérisé en ce que la tension aux bornes du condensateur (C1) est détectée par un inverseur (33) dont la deuxième borne est connectée à une borne d'activation du circuit de commande de grille (22).

7. Circuit de protection selon la revendication 1, caractérisé en ce que le courant de décharge (IDIS) est obtenu à partir d'un miroir de courant recopiant, éventuellement avec un facteur de division, le courant dans un transistor de détection (44) constitué d'un certain nombre de cellules identiques aux cellules constituant le transistor de puissance.

8. Circuit de protection selon la revendication 1, caractérisé en ce que la source de courant de décharge du condensateur (C1) est constituée d'un transistor (47) en série avec une résistance (48), le point de connexion de ce transistor et de cette résistance étant relié à l'entrée inverseuse d'un amplificateur opérationnel (49) dont l'entrée non-inverseuse reçoit le courant (IS) du transistor de détection et est reliée à la masse par l'intermédiaire d'une résistance de polarisation (50).

## Patentansprüche

1. Schaltung zum Schutz eines Leistungstransistors vom vertikalen MOS-Typ oder vom IGBT-Typ im Sperrzustand beim Auftreten von Überspannungen in Vorwärtsrichtung (Durchlaßrichtung), umfassend:

- erste Schaltmittel (Z1, D1) zur Einschaltung in den leitenden Zustand zur Begrenzung der Spannung an den Anschlüssen des Leistungstransistors auf eine vorgegebene Spannung (VZ1+VF+VGS), die kleiner als die Durchlaß-Durchbruchspannung des Leistungstransistors ist,

- Detektionsschaltmittel (24) zum Nachweis der in dem Leistungstransistor freigesetzten Energiemenge während der Aktivierung der ersten Schaltmittel,

- zweite Schaltmittel (22, 23) zur Einschaltung des Leistungstransistors in den leitenden Zustand mit niedriger Impedanz, die aktiviert werden, sobald die Detektionsschaltmittel festgestellt haben, daß die freigesetzte Dissipationsenergie einen vorgegebenen Energieschwellwert überstiegen hat,

dadurch gekennzeichnet, daß die Detektionsschaltmittel umfassen:

- Schaltmittel (ICHG) zum Laden eines Kondensators (C1) auf eine vorgegebene Spannung (VZ2), während der Leistungstransistor sich im Sperrzustand befindet,

- Schaltmittel (32) zur Unterbrechung der Aufladung des Kondensators sowie Schaltmittel zur Entladung des Kondensators mit einem Entladestrom (IDIS) proportional dem Strom im Leistungstransistor, sobald der Leistungstransistor unter dem Einfluß der ersten Schaltmittel leitend zu werden beginnt, sowie

- Detektionsschaltmittel zur überwachung der Spannung an den Anschlüssen des Kondensators.

2. Schutzschaltung nach Anspruch 1,
dadurch gekennzeichnet, daß die ersten Schaltmittel eine Reihenschaltung aus einer Zener-Diode (Z1) und einer entgegengesetzt gepolten Diode (D1) aufweisen, wobei diese Reihenschaltung zwischen dem Drain-Anschluß und dem Gate des Leistungstransistors liegt.

3. Schutzschaltung nach Anspruch 1,
dadurch gekennzeichnet, daß die zweiten Schaltmittel Betätigungsmittel (23) für eine Gate-Steuerschaltung (22) aufweisen.

**4.** Schaltung nach den Ansprüchen 1 und 2,
dadurch gekennzeichnet, daß die Lademittel eine Stromquelle aufweisen, welche von einem Inverter (32) gesteuert wird, dessen Eingangsanschluß einerseits über einen hohen Widerstand (R1) mit Masse und andererseits mit dem Verbindungspunkt zwischen der genannten Zener-Diode (Z1) und der genannten Diode (D1) verbunden ist.

**5.** Schutzschaltung nach Anspruch 1,
dadurch gekennzeichnet, daß der genannte Kondensator (C1) in Parallelschaltung mit einer Zener-Diode (Z2) geschaltet ist, welche die maximale Ladespannung fixiert.

**6.** Schutzschaltung nach Anspruch 1,
dadurch gekennzeichnet, daß die Spannung an den Anschlüssen des Kondensators (C1) durch einen Inverter (33) nachgewiesen bzw. detektiert wird, dessen zweiter Anschluß mit einem Betätigungsanschluß für die Gate-Steuerschaltung (22) verbunden ist.

**7.** Schutzschaltung nach Anspruch 1,
dadurch gekennzeichnet, daß der Entladestrom (IDIS) von einem Stromspiegel abgeleitet wird, welcher gegebenenfalls mit einem Teilungsfaktor den Strom in einem Detektionstransistor (44) dupliziert, der aus einer bestimmten Anzahl von mit den den Leistungstransistor bildenden Zellen identischen Zellen besteht.

**8.** Schutzschaltung nach Anspruch 1,
dadurch gekennzeichnet, daß die Entladestromquelle für den Kondensator (C1) von einem Transistor (47) in Reihe mit einem Widerstand (48) gebildet wird, wobei die Verbindungsstelle dieses Transistors mit diesem Widerstand mit dem invertierenden Eingang eines Operationsverstärkers (49) verbunden ist, dessen nicht-invertierender Eingang den Strom (IS) des Detektionstransistors zugeführt erhält und über einen Vorspannwiderstand (50) mit Masse verbunden ist.

**Claims**

**1.** A protection circuit for protecting a power transistor of the vertical MOS or IGBT-type during an off state against forward overvoltages, including:

first turn-on means (Z1, D1) for clamping the voltage across the power transistor to a predetermined voltage (VZ1+VF+VGS) lower than the forward breakdown voltage of the power transistor,
detection means (24) for detecting the quantity of energy dissipated in the power transistor when said first means are enabled,
second turn-on means (22, 23) for turning on the power transistor at a low impedance, said second means being enabled when said detection means have detected that the dissipated energy has exceeded said predetermined energy threshold,

characterized in that said detection means include:

means (ICHG) for charging a capacitor (C1) at a predetermined voltage (VZ2) while said power transistor is in the off state,
means (32) for interrupting charging of said capacitor (C1), and means for discharging the capacitor by a discharge current (IDIS) proportional to the current in the power transistor, as soon as said power transistor starts being conductive under the influence of said first means, and
means for detecting the voltage across said capacitor.

**2.** The protection circuit of claim 1, characterized in that said first means comprise the serial connection of a zener diode (Z1) and a reverse biased diode (D1), said serial connection being connected between drain and gate of the power transistor.

**3.** The protection circuit of claim 1, characterized in that said second means include means (23) for activating a gate drive circuit (22).

**4.** The protection circuit of claims 1 and 2, characterized in that the charging means include a current source controlled by an inverter (32) whose input terminal is connected both to ground through a high value resistor (R1) and to the junction of said zener diode (Z1) and said diode (D1).

5. The protection circuit of claim 1, characterized in that said capacitor (C1) is parallel connected with a zener diode (Z2) operable to set the maximum charge voltage.

6. The protection circuit of claim 1, characterized in that the voltage across said capacitor (C1) is detected by an inverter (33) whose second terminal is connected to a terminal operable to enable said gate drive circuit (22).

7. The protection circuit of claim 1, characterized in that the discharge current (IDIS) is obtained from a current mirror duplicating, if required with a dividing factor, the current in a detection transistor (44) formed by a determined number of cells identical to the cells forming the power transistor.

8. The protection circuit of claim 1, characterized in that the discharge current source of said capacitor (C1) is formed by a transistor (47) connected in series with a resistor (48), the junction of said transistor (47) and resistor (48) being connected to the inverting input of an operational amplifier (49) whose non-inverting input receives the current (IS) from the detection transistor and is connected to ground through a biasing resistor (50).

Fig 1

Fig 2A

Fig 2B

Fig 3

Fig 4

Fig 5

Fig 6